# EUROPEAN PATENT SPECIFICATION

(11) **EP 3 771 304 B1**
(45) Date of publication and mention of the grant of the patent: **30.08.2023**
(21) Application number: 18910367.4
(22) Date of filing: 29.12.2018
(51) Int. Cl.: H05K 5/02, H05K 5/03

(54) **ELECTRONIC CONTROL BOX STRUCTURE AND WALL-MOUNTED AIR CONDITIONER**
STRUKTUR EINES ELEKTRONISCHEN STEUERKASTENS UND WANDMONTIERTE KLIMAANLAGE
STRUCTURE DE BOÎTIER DE COMMANDE ÉLECTRONIQUE ET CLIMATISEUR MURAL

(30) Priority: 23.03.2018 CN 201820405720 U
(43) Date of publication of application: 27.01.2021
(73) Proprietor: Ningbo Aux Electric Co., Ltd., Ningbo, Zhejiang 315000 (CN); Aux Air Conditioner Co., Ltd, Jiangshan Town, Yinzhou District Ningbo Zhejiang 315191 (CN)
(72) Inventor: LIU, Wenliang, Ningbo, Zhejiang 315191 (CN); ZHANG, Kunpeng, Ningbo, Zhejiang 315191 (CN); SHANG, Bin, Ningbo, Zhejiang 315191 (CN); ZHANG, Huazhong, Ningbo, Zhejiang 315191 (CN)
(74) Representative: Locas, Davide
(86) International application number: PCT/CN2018/125509
(87) International publication number: WO 2019/179203

(56) References cited:
- CN-U- 202 335 120
- CN-U- 203 404 862
- CN-U- 206 176 671
- CN-U- 206 546 951
- CN-U- 208 029 239
- CN-Y- 201 123 175
- JP-A- 2003 314 127
- KR-U- 20100 011 683

## Description

### FIELD OF THE INVENTION

The present invention relates to the technical field of air conditioners, in particular to an electronic control box structure and a wall-mounted air conditioner.

### BACKGROUND OF THE INVENTION

For electronic control as an important part of maintenance for air conditioner, the electronic control box cover must be opened firstly to withdraw the control panel when the maintenance of the electronic control for the wall-mounted machine is required.

The electronic control box cover on existing wall-mounted air conditioners on the market is mounted and fixed by fixing the other end of the electronic control box cover to the housing with screws through the insertion of two bumps on the upper end of the electronic control box cover into the mounting hole on the housing. For example, CN201123175Y discloses an air conditioner electrical equipment box and an air conditioner, and KR20100011683U discloses an inverter in which a front cover is hinged to a body cover.

During the maintenance of the electronic control, the electronic control box cover will fall automatically due to gravity when being opened, or the electronic control box cover is removed and placed nowhere when there are assemblies connected to the electronic control box cover, which causes inconvenience of maintenance and certain security risks. During the existing maintenance of the electronic control, since the position where the electronic control box cover is opened cannot be fixed, or the electronic control box cover must be removed for placement, it brings inconvenience to maintenance personnel.

### SUMMARY OF THE INVENTION

In view of this, the present invention aims at providing an electronic control box structure to improve the problem of being unable to fix the box cover with respect to the box body after the existing electronic control box cover is opened, so as to facilitate the working personnel to repair the electronic control box. In the present invention, the design of the electronic control box structure is reasonable, ingenious, simple, and practical, and the electronic control box cover is convenient to be fixed after being opened relative to the electric control box body and will not fall down automatically, thereby facilitating maintenance and further improving the quality of the product.

To achieve the above purpose, the technical solution of the present invention is implemented as an electronic control box structure including an electronic control box body and an electronic control box cover as defined in appended claim 1.

The electronic control box body includes an opening end, a side of the opening end is fixedly provided with a connecting portion and a positioning portion, and a side of the electronic control box cover is provided with a cooperating portion and a latching portion. The cooperating portion is rotatably connected to the connecting portion, and the latching portion is engaged with the positioning portion, such that the electronic control box cover is opened with a fixed angle relative to the electronic control box body. The connecting portion is a fixed rotation shaft, and the cooperating portion is a rotation hanging ear cooperating with the fixed rotation shaft; or the cooperating portion is the fixed rotation shaft, and the connecting portion is the rotation hanging ear cooperating with the fixed rotation shaft. The rotation hanging ear is rotatably hung to the fixed rotation shaft, and a reinforcing rib is disposed at one side in a thickness direction of the rotation hanging ear. The reinforcing rib is disposed along a circumferential direction of the rotation hanging ear and has an L-shaped structure. The reinforcing rib has a height of 1 to 5 mm.

Further, the rotation hanging ear includes a rotation hole and blocking bumps located at an opening of the rotation hole, the rotation hole cooperates with the fixed rotation shaft, and the blocking bumps are used to block the fixed rotation shaft from being disengaged from the rotation hole.

Further, the blocking bumps have two bumps, which are respectively located at two sides of the opening of the rotation hole, and the two blocking bumps are disposed oppositely.

Further, the positioning portion includes at least one positioning boss, the positioning boss includes a locking side, and the latching portion is provided with latching bumps. The cooperating portion of the electronic control box cover rotates around the connecting portion of the electronic control box body, and the latching bumps cooperate with and are latched with the locking side of the positioning boss.

Further, the position boss has two bosses, the two positioning bosses are disposed at intervals, and the latching bumps are selectively disposed on the locking side of one of the positioning bosses.

Compared with the prior art, the electronic control box structure of the present invention has the following advantages:
In the present invention, the design of the electronic control box structure is reasonable and simple, the electronic control box cover is fixed at an angle when it is opened relative to the electronic control box body while being kept in a certain position without falling down automatically, so as to facilitate the staff to maintain the electronic control box structure, thereby using conveniently and having strong practicality.

Another object of the present invention is to provide a wall-mounted air conditioner, which has the same advantages as the above electronic control box structure.

Compared with the prior art, the wall-mounted air conditioner of the present invention has the following advantages:
The electronic control box structure in the wall-mounted air conditioner is maintained conveniently, the electronic control box cover is not easy to automatically fall or be thrown away after being opened without affecting the maintenance operation. The opening and closing for the electronic control box cover is easy to operate, thereby having strong practicality.

The wall-mounted air conditioner has the same advantages as the above-mentioned electronic control box structure over the prior art, and the advantages are not repeated here.

### BRIEF DESCRIPTION OF THE DRAWINGS

Aspects of the present invention are best understood from the following detailed description when read with the accompanying figures. The exemplary embodiments of the present invention and the description thereof are used to explain the present invention, and do not constitute improper limitations on the preset invention. In the drawings:
Fig. 1 is a structural diagram of an electronic control box structure in a closed state according to Embodiment 1 of the present invention.
Fig. 2 is a structural diagram of an electronic control box structure in an opened state according to Embodiment 1 of the present invention.
Fig. 3 is a structural diagram of a part of an electronic control box cover in an electronic control box structure according to Embodiment 1 of the present invention.
Fig. 4 is a structural diagram of a part of an electronic control box body in an electronic control box structure according to Embodiment 1 of the present invention.
Fig. 5 is a structural diagram of the electronic control box cover before being fixed with the electronic control box body of the electronic control box structure during the opening process according to Embodiment of the present invention.
Fig. 6 is a structural diagram of the electronic control box cover of the electronic control box structure and the electronic control box body are at a first fixed angle according to Embodiment 1 of the present invention.
Fig. 7 is an enlarged structural view at location A in the electronic control box structure according to Embodiment 1 of the present invention.
Fig. 8 is an enlarged structural view at location B in the electronic control box structure according to Embodiment 1 of the present invention.
Fig. 9 is a partial enlarged structural view of the electronic control box cover of the electronic control box structure and the electronic control box body are at a second fixed angle according to Embodiment 1 of the present invention.

List of serial numbers in the figures:

| | |
|---|---|
| 1 - Electronic control box structure; | 2 - Electronic control box body; |
| 3 - Electronic control box cover; | 4 - Connecting portion; |
| 5 - Positioning portion; | 6 - Cooperating portion; |
| 7 - Latching portion; | 8 - Rotation hanging ear; |
| 9 - Latching bump; | 10 - Fixed rotation shaft; |
| 11 - Positioning boss; | 12 - Blocking bump; |
| 13 - Reinforcing rib; | 14 - Locking side; |
| 15 - Recessed groove. | |

### DESCRIPTION OF THE PREFERRED EMBODIMENTS

The present invention is described in detail with reference to drawings and with regard to the following embodiment.

### Embodiment 1

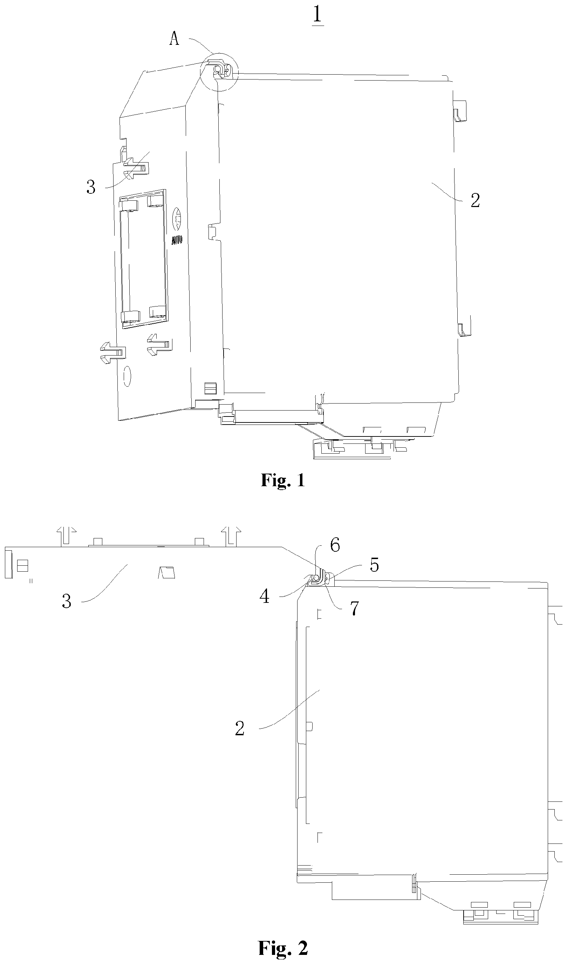

Fig. 1 is a structural diagram of an electronic control box structure 1 in a closed state according to Embodiment 1. With reference to Fig. 1, the electronic control box structure 1 includes an electronic control box body 2 and an electronic control box cover 3, wherein the electronic control box cover 3 is buckled on the electronic control box body 2, and the electronic control box cover 3 opens the electronic control box by rotating with respect to the electronic control box body 2.

Fig. 2 is a structural diagram of an electronic control box structure 1 in an opened state according to Embodiment 1. With reference to Fig. 2, the electronic control box body 2 includes a receiving cavity opened at one end, and one side of an opening end of the electronic control box body 2 is provided with a connecting portion 4 and a positioning portion 5, wherein both the connecting portion 4 and the positioning portion 5 are fixedly disposed on the electronic control box body 2. One side of the electronic control box cover 3 is provided with a cooperating portion 6 and a latching portion 7, wherein the cooperating portion 6 on the electronic control box cover 3 is cooperatively connected to the connecting portion 4 on the electronic control box body 2, so that the electronic control box cover 3 may rotate relative to the electronic control box body 2 for thereby opening or closing the electronic control box body 2.

The latching portion 7 on the electronic control box cover 3 cooperates with the positioning portion 5 on the electronic control box body 2, so that the electronic control box cover 3 is fixed at an angle in the opened state, thereby facilitating the staff to maintain the control panel and other components in the electronic control box.

The specific structure of each component of the electronic control box structure 1 and the corresponding relationship between them will be described in detail below.

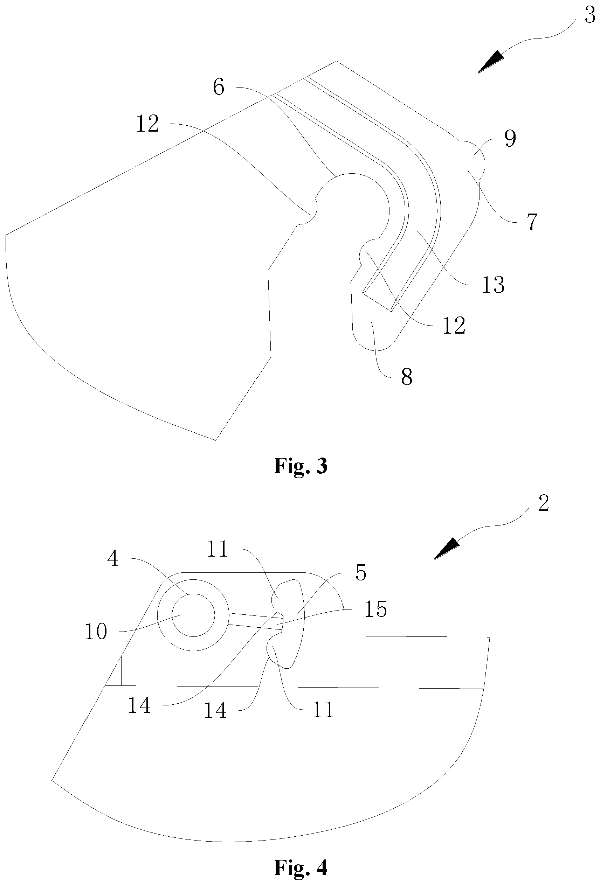

Fig. 3 is a structural diagram of a part of an electronic control box cover 3 in an electronic control box structure 1 according to Embodiment 1. Fig. 4 is a structural diagram of a part of an electronic control box body 2 in an electronic control box structure 1 according to Embodiment 1. With reference to Figs. 3 and 4, the cooperating portion 6 in the electronic control box cover 3 is a rotation hanging ear 8, and the latching portion 7 is provided with latching bumps 9; the connecting portion 4 of the electronic control box body 2 is a fixed rotation shaft 10, and the positioning portion 5 is provided with positioning bosses 11. Among them, the rotation hanging ear 8 is disposed on the fixed rotation shaft 10, and rotate around the fixed rotation shaft 10. During rotation, the latching bumps 9 may rotate synchronously with the electronic control box cover 3 around the fixed rotation shaft 10, and the latching bumps 9 have a state before being fixed with the positioning bosses 11 and a state after being fixed with the positioning bosses 11.

It is to be understood that the connecting portion 4 of the electronic control box body 2 is the rotation hanging ear 8, the cooperating portion 6 of the electronic control box cover 3 is the fixed rotation shaft 10, and the rotation hanging ear 8 is hung on the fixed rotation shaft 10 and rotates around the fixed rotation shaft 10, so that the electronic control box cover 3 is rotatably connected to the electronic control box body 2. Both of the above-mentioned setting methods are possible, as long as the electronic control box cover 3 and the electronic control box body 2 are rotatably connected with each other. During the relative rotation, the latching bumps 9 cooperate with the positioning bosses 11, so that the electronic control box cover 3 is in the opened state and in a state where the opening angle is fixed relative to the electronic control box body 2.

In Embodiment 1, the electronic control box cover 3 is provided with the rotation hanging ear 8, and the electronic control box body 2 is provided with the fixed rotation shaft 10, wherein the rotation hanging ear 8 is rotatably hung on the fixed rotation shaft 10, and the rotation hanging ear 8 may rotate around the fixed rotation shaft 10. In order to prevent the electronic control box cover 3 from falling down with respect to the electronic control box body 2 due to the disengagement of the fixed rotation shaft 10 from the rotation hanging ear 8, the rotation hanging ear 8 includes a rotation hole and blocking bumps 12 located at an opening of the rotation hole on the electronic control box cover 3 according to the present Embodiment, wherein the blocking bumps 12 protrude to the outside to exert a certain resistance for the fixed rotation shaft 10, so as to better limit the fixed rotation shaft 10.

When the rotation hanging ear 8 is hung on the fixed rotation shaft 10, it is convenient to hang and not easy to come off. In addition to the above-mentioned blocking bumps 12, it is also necessary to satisfy a certain strength, so reinforcing ribs 13 are provided on one side in the thickness direction of the rotation hanging ear 8.

In Embodiment 1, the reinforcing ribs 13 are arranged along a circumferential direction of the rotating hanging ear 8 and have an L-shaped structure; considering that the strength of the rotation hanging ear 8 is not easy to be too large to be hung on the fixed rotation shaft 10, and considering that the strength of the rotation hanging ear 8 is not easy to be too small to prevent the electronic control box cover 3 from being rotated relative to the electronic control box body 2 during the rotation and from sliding out of the fixed rotation shaft 10 to cause the electronic control box cover 3 to fall down, a height of the reinforcing rib 13 is design to be 1 to 5mm, so that the connection strength between the electronic control box cover 3 and the electronic control box body 2 is satisfied.

The blocking bump 12 is one bump, or two bumps. In the present embodiment, the blocking bump 12 has two bumps, and the two blocking bumps 12 are located at both sides of the opening of the rotation hole respectively and the two blocking bumps 12 are disposed oppositely, so as to limit the fixed rotation shaft 10 in two directions for achieving better limitation, thereby preventing the electronic control box cover 3 from being slide out and creating a firm connection relative to the electronic control box body 2 during rotation.

The electronic control box body 2 includes the fixed rotation shaft 10 and the positioning portion 5, wherein the positioning portion 5 is provided with at least one positioning boss 11, and the positioning boss 11 may cooperate with the latching bumps 9 of the electronic control box cover 3. During the rotation of the electronic control box cover 3 relative to the electronic control box body 2, the latching bumps 9 are in an interference fit with the positioning bosses 11. After the latching bumps 9 are engaged with the positioning bosses 11, the electronic control box cover 3 is in the opened state with respect to the electronic control box body 2, and the opening angle between the electronic control box cover 3 and the electronic control box body 2 is fixed, so as to facilitate the staff to detect.

In Embodiment 1, the positioning portion 5 includes two positioning bosses 11, and the positioning bosses 11 have locking sides 14. During the rotation of the rotation hanging ear 8 of the electronic control box cover 3 around the fixed rotation shaft 10 of the electronic control box body 2, the latching bumps 9 of the electronic control box cover 3 may cooperate with and be latched with the locking sides 14 of each of the positioning bosses 11 respectively. The two positioning bosses 11 make the electronic control box cover 3 have two opened fixed states with different angles.

Specifically, the two positioning bosses 11 are disposed at intervals, a recessed groove 15 is formed between the two positioning bosses 11, and the latching bumps 9 of the electronic control box cover 3 is latched in the recessed groove 15 between the two positioning bosses 11, so that during the rotation of the electronic control box cover 3, the latching bumps 9 may selectively disposed in a locking side 14 of one of the positioning bosses 11.

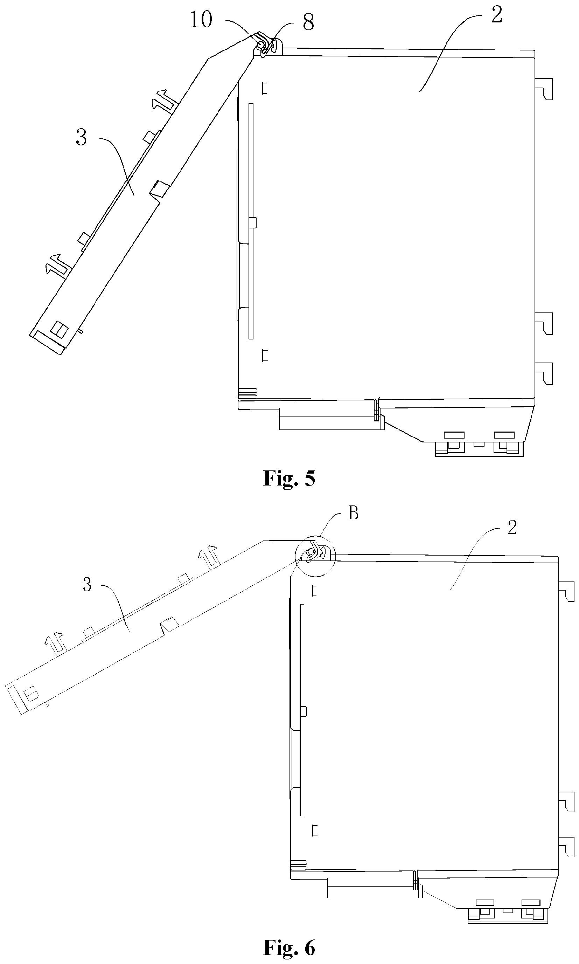

Fig. 5 is a view of the structure of the electronic control box cover 3 before being fixed with the electronic control box body 2 during the opening process in an electronic control box structure 1 according to Embodiment 1. Fig. 6 is a view of the structure of the electronic control box cover 3 being fixed with the electronic control box body 2 at a first fixed angle in an electronic control box structure 1 according to Embodiment 1.

With reference to Figs. 5 and 6, the rotation hanging ear 8 rotates around the fixed rotation shaft 10, and the latching bumps 9 contact with the positioning bosses 11, so that when the latching bumps 9 rotate to the locking sides 14 of the positioning bosses 11, the electronic control box cover 3 is fixed relative to the electronic control box body 2, at which time the electronic control box is in the opened state.

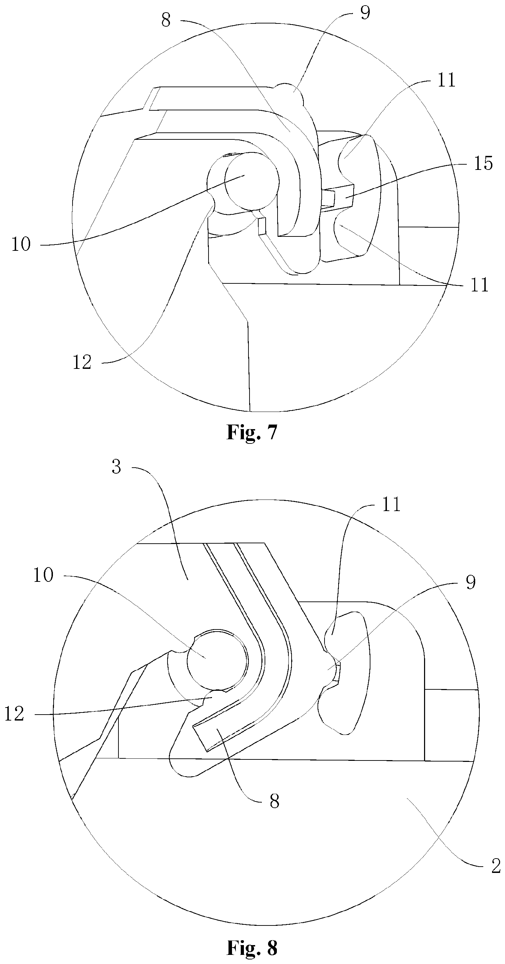

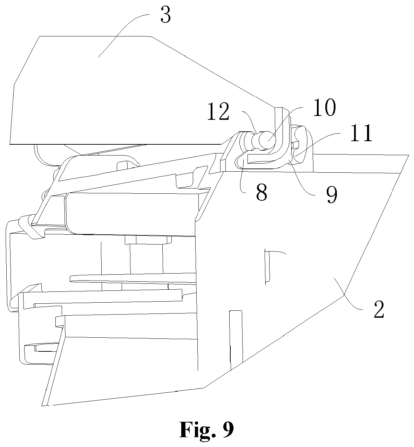

Fig. 7 is an enlarged structural view at location A in the electronic control box structure 1 provided in Embodiment 1. Fig. 8 is an enlarged view of the structure at B in the electronic control box structure 1 provided in Embodiment 1. Fig. 9 is a partially enlarged view of the structure of the electronic control box cover 3 being fixed with the electronic control box body 2 at a second fixed angle in an electronic control box structure 1 according to Embodiment 1. With reference to Figs. 7, 8 and 9, in a normal state, the electronic control box structure 1 is in the state shown in Fig. 7, i.e., the electronic control box cover 3 is closed relative to the electronic control box body 2.

When the electronic control box is required for maintenance, the electronic control box cover 3 is rotated to open relative to the electronic control box body 2, and when the electronic control box cover 3 is rotated to the state shown in Fig. 8, the electronic control box cover 3 opened relative to the electronic control box body 2 at an angle of 45° to 70°, which facilitates the staff to perform normal maintenance, wiring and checking for the electronic control box.

Then, the electronic control box cover 3 is rotated continuously to open relative to the electronic control box body 2, and when the electronic control box cover 3 is rotated to the state shown in Fig. 9, the electronic control box cover 3 opened relative to the electronic control box body 2 at an angle of 75° to 105°, which facilitates the staff to take out the main board of the controller for maintenance.

The electronic control box structure 1 provided by Embodiment 1 of the present invention has the following benefits:
The design is reasonable, and the structure is simple; by opening the electronic control box cover 3 relative to the electronic control box body 2 through rotation, the latching bumps 9 on the electronic control box cover 3 cooperate with and are fixed with the positioning bosses 11 on the electronic control box body 2, so as to open the electronic control box cover 3 relative to the electronic control box body 2 and maintain at a fixed opening angle. This not only facilitates the maintenance of the electronic control box by the staff, but also prevents the electronic control box cover 3 from falling or being lost. The electronic control box structure 1 has strong practicability and wide application range.

Another embodiment of the present invention provides a wall-mounted air conditioner, which includes a housing and the electronic control box structure 1. The electronic control box structure 1 is fixedly disposed on the housing through the electronic control box body 2, and the electronic control box cover 3 is rotatably disposed on the electronic control box body 2.

During normal use, the electronic control box cover 3 is buckled on the electronic control box body 2, and when the electronic control box is required for maintenance, the electronic control box cover 3 is rotated such that the electronic control box cover 3 is opened relative to the electronic control box body 2 with a fixed opening angle, so the electronic control box cover 3 will not fall down automatically.

The wall-mounted air conditioner better solves the problem that the opening position of the electronic control box cover 3 may not be fixed or the electronic control box cover 3 must be removed, so that the electronic control box cover 3 is opened and fixed at a certain position, which facilitates the staff to maintain.

## Claims

1. An electronic control box structure (1), wherein the electronic control box structure (1) comprises an electronic control box body (2) and an electronic control box cover (3);
the electronic control box body (2) comprises an opening end, a side of the opening end is fixedly provided with a connecting portion (4) and a positioning portion (5), and a side of the electronic control box cover (3) is provided with an cooperating portion (6) and a latching portion (7);
the cooperating portion (6) is rotatably connected to the connecting portion (4), and the latching portion (7) can engage the positioning portion (5), such that the electronic control box cover (3) is opened with a fixed angle relative to the electronic control box body (2),
the connecting portion (4) is a fixed rotation shaft (10), and the cooperating portion (6) is a rotation hanging ear (8) cooperating with the fixed rotation shaft (10); or the cooperating portion (6) is the fixed rotation shaft (10), and the connecting portion (4) is the rotation hanging ear (8) cooperating with the fixed rotation shaft (10),
the rotation hanging ear (8) is rotatably hung to the fixed rotation shaft (10), wherein a reinforcing rib (13) is disposed at one side in a thickness direction of the rotation hanging ear (8),
the reinforcing rib (13) is disposed along a circumferential direction of the rotation hanging ear (8) and has an L-shaped structure, and
the reinforcing rib (13) has a height of 1 to 5 mm.

2. The electronic control box structure according to claim 1, wherein the rotation hanging ear (8) comprises a rotation hole and blocking bumps (12) located at an opening of the rotation hole, the rotation hole cooperates with the fixed rotation shaft (10), and the blocking bumps (12) are used to block the fixed rotation shaft (10) from being disengaged from the rotation hole.

3. The electronic control box structure according to claim 2, wherein the blocking bumps (12) have two bumps, which are respectively located at two sides of the opening of the rotation hole, and the two blocking bumps (12) are disposed oppositely.

4. The electronic control box structure according to claim 3, wherein the positioning portion (5) comprises at least one positioning boss (11), the positioning boss (11) comprises a locking side (14), and the latching portion (7) is provided with latching bumps (9);
the cooperating portion (6) of the electronic control box cover (3) rotates around the connecting portion (4) of the electronic control box body (2), and the latching bumps (9) cooperate with and are latched with the locking side (14) of the positioning boss (11).

5. The electronic control box structure according to claim 4, wherein the position boss (11) has two bosses, the two positioning bosses (11) are disposed at intervals, and the latching bumps (9) is selectively disposed on the locking side (14) of one of the positioning bosses (11).

6. A wall-mounted air conditioner, **characterized in that**, the wall-mounted air conditioner comprises a housing and the electronic control box structure (1) according to any one of claims 1 to 5, wherein the electronic control box body (2) is fixedly disposed on the housing, the electronic control box cover (3) is disposed rotatably on the electronic control box body (2), and the electronic control box cover (3) has a first state wherein it is buckled with the electronic control box body (2) and a second state that it is opened and fixed at an angle relative to the electronic control box body (2).

## Patentansprüche

1. Elektronische Steuerboxstruktur (1), wobei die elektronische Steuerboxstruktur (1) einen elektronischen Steuerboxkörper (2) und eine elektronische Steuerboxabdeckung (3) aufweist;
- wobei der elektronische Steuerboxkörper (2) ein Öffnungsende aufweist, eine Seite des Öffnungsendes fest mit einem Verbindungsabschnitt (4) und einem Positionierungsabschnitt (5) versehen ist und eine Seite der elektronischen Steuerboxabdeckung (3) mit einem zusammenwirkenden Abschnitt (6) und einem Einrastabschnitt (7) versehen ist;
- wobei der zusammenwirkende Abschnitt (6) drehbar mit dem Verbindungsabschnitt (4) verbunden ist, und der Einrastabschnitt (7) in den Positionierungsabschnitt (5) eingreifen kann, so dass die elektronische Steuerboxabdeckung (3) in einem festen Winkel relativ zum elektronischen Steuerboxkörper (2) geöffnet wird,
- wobei der Verbindungsabschnitt (4) eine feststehende Drehwelle (10) ist und der zusammenwirkende Abschnitt (6) eine drehbare Aufhängung (8) ist, die mit der feststehenden Drehwelle (10) zusammenwirkt; oder der zusammenwirkende Abschnitt (6) die feststehende Drehwelle (10) ist und der Verbindungsabschnitt (4) die drehbare Aufhängung (8) ist, die mit der feststehenden Drehwelle (10) zusammenwirkt,
- wobei die drehbare Aufhängung (8) drehbar an der feststehenden Drehwelle (10) aufgehängt ist,
- wobei eine Verstärkungsrippe (13) an einer Seite in einer Dickenrichtung der drehbaren Aufhängung (8) angeordnet ist,
- wobei die Verstärkungsrippe (13) entlang einer Umfangsrichtung der drehbaren Aufhängung (8) angeordnet ist und eine L-förmige Struktur aufweist, und die Verstärkungsrippe (13) eine Höhe von 1 bis 5 mm aufweist.

2. Elektronische Steuerboxstruktur nach Anspruch 1, wobei die drehbare Aufhängung (8) ein Drehloch und Blockierungshöcker (12) aufweist, die sich an einer Öffnung des Drehlochs befinden, wobei das Drehloch mit der feststehenden Drehwelle (10) zusammenwirkt und die Blockierungshöcker (12) verwendet werden, um zu verhindern, dass die feststehende Drehwelle (10) aus dem Drehloch gelöst wird.

3. Elektronische Steuerboxstruktur nach Anspruch 2, wobei die Blockierungshöcker (12) zwei Höcker aufweisen, die jeweils an zwei Seiten der Öffnung des Drehlochs angeordnet sind und die beiden Blockierungshöcker (12) gegenüberliegend angeordnet sind.

4. Elektronische Steuerboxstruktur nach Anspruch 3, wobei der Positionierungsabschnitt (5) zumindest einen Positionierungsvorsprung (11) aufweist, der Positionierungsvorsprung (11) eine Verriegelungsseite (14) aufweist und der Einrastabschnitt (7) mit Einrasthöckern (9) versehen ist;
wobei sich der zusammenwirkende Abschnitt (6) der elektronischen Steuerboxₐbdeckung (3) um den Verbindungsabschnitt (4) des elektronische Steuerboxkörpers (2) dreht, und die Einrasthöcker (9) mit der Verriegelungsseite (14) des Positionierungsvorsprungs (11) zusammenwirken und mit dieser eingerastet sind.

5. Elektronische Steuerboxstruktur nach Anspruch 4, wobei der Positionsvorsprung (11) zwei Vorsprünge aufweist, die beiden Positionierungsvorsprünge (11) in Abständen angeordnet sind und die Einrasthöcker (9) selektiv auf der Verriegelungsseite (14) eines der Positionierungsvorsprünge (11) angeordnet sind.

6. Wandklimagerät, **dadurch gekennzeichnet, dass** das Wandklimagerät ein Gehäuse und die elektronische Steuerboxstruktur (1) nach einem der Ansprüche 1 bis 5 aufweist, wobei der elektronische Steuerboxkörper (2) fest am Gehäuse angeordnet ist, die elektronische Steuerboxabdeckung (3) drehbar am elektronischen Steuerboxkörper (2) angeordnet ist und die elektronische Steuerboxabdeckung (3) einen ersten Zustand aufweist, in dem sie mit dem elektronischen Steuerboxkörper (2) verformt ist, und einen zweiten Zustand aufweist, bei dem sie geöffnet ist und in einem Winkel relativ zum elektronischen Steuerboxkörper (2) befestigt ist.

## Revendications

1. Structure de boîtier de commande électronique (1), où la structure de boîtier de commande électronique (1) comprend un corps de boîtier de commande électronique (2) et un couvercle de boîtier de commande électronique (3);
le corps de boîtier de commande électronique (2) comprend une extrémité d'ouverture, un côté de l'extrémité d'ouverture est muni de manière fixe d'une partie de liaison (4) et d'une partie de positionnement (5), et un côté du couvercle de boîtier de commande électronique (3) est muni d'une partie coopérante (6) et d'une partie de verrouillage (7);
la partie coopérante (6) est reliée de manière rotative à la partie de liaison (4), et la partie de verrouillage (7) peut s'engager avec la partie de positionnement (5), de sorte que le couvercle de boîtier de commande électronique (3) est ouvert avec un angle fixé par rapport au corps de boîtier de commande électronique (2),
la partie de liaison (4) est une tige de rotation fixée (10), et la partie coopérante (6) est une oreille en suspension de rotation (8) coopérant avec la tige de rotation fixée (10); ou la partie coopérante (6) est la tige de rotation fixée (10), et la partie de liaison (4) est l'oreille en suspension de rotation (8) coopérant avec la tige de rotation fixée (10),
l'oreille en suspension de rotation (8) est suspendue de manière rotative à la tige de rotation fixée (10),
où
une nervure de renforcement (13) est disposée au niveau d'un côté dans une direction de l'épaisseur de l'oreille en suspension de rotation (8),
la nervure de renforcement (13) est disposée le long d'une direction circonférentielle de l'oreille en suspension de rotation (8) et a une structure en forme de L, et
la nervure de renforcement (13) a une hauteur de 1 à 5 mm.

2. Structure de boîtier de commande électronique selon la revendication 1, dans laquelle l'oreille en suspension de rotation (8) comprend un trou de rotation et des bosses de blocage (12) situées au niveau d'une ouverture du trou de rotation, le trou de rotation coopère avec la tige de rotation fixée (10 ), et les bosses de blocage (12) sont utilisées pour empêcher la tige de rotation fixée (10) d'être désengagée du trou de rotation.

3. Structure de boîtier de commande électronique selon la revendication 2, dans laquelle les bosses de blocage (12) ont deux bosses, qui sont situées respectivement au niveau de deux côtés de l'ouverture du trou de rotation, et les deux bosses de blocage (12) sont disposées de manière opposée.

4. Structure de boîtier de commande électronique selon la revendication 3, dans laquelle la partie de positionnement (5) comprend au moins une protubérance de positionnement (11), la protubérance de positionnement (11) comprend un côté de blocage (14), et la partie de verrouillage (7) est munie de bosses de verrouillage (9);
la partie coopérante (6) du couvercle de boîtier de commande électronique (3) tourne autour de la partie de liaison (4) du corps de boîtier de commande électronique (2), et les bosses de verrouillage (9) coopèrent avec et sont verrouillées avec le côté de blocage (14) de la protubérance de positionnement (11).

5. Structure de boîtier de commande électronique selon la revendication 4, dans laquelle la protubérance de position (11) a deux protubérances, les deux protubérances de positionnement (11) sont disposées à intervalles, et les bosses de verrouillage (9) sont disposées sélectivement sur le côté de blocage (14) de l'une des protubérances de positionnement (11).

6. Climatiseur mural, **caractérisé en ce que**, le climatiseur mural comprend un logement et la structure de boîtier de commande électronique (1) selon l'une quelconque des revendications 1 à 5, dans lequel le corps de boîtier de commande électronique (2) est disposé de manière fixe sur le logement, le couvercle de boîtier de commande électronique (3) est disposé de manière rotative sur le corps de boîtier de commande électronique (2), et le couvercle de boîtier de commande électronique (3) a un premier état dans lequel il est serré avec le corps de boîtier de commande électronique (2) et un second état qu'il est ouvert et fixé à un angle par rapport au corps de boîtier de commande électronique (2).
